# EUROPEAN PATENT APPLICATION

(11) **EP 4 650 788 A1**
(43) Date of publication of application: **19.11.2025**
(21) Application number: 25175276.2
(22) Date of filing: 09.05.2025
(51) Int. Cl.: G01R 1/02

(54) **AUTOMATIC EXECUTION OF ELECTRICAL TESTING AND STORING RESULTS**

(30) Priority: 10.05.2024 US 202463645696 P
(71) Applicant: Fluke Corporation, Everett, WA 98203 (US)
(72) Inventor: PATEL, Jeetendra, Everett, 98203 (US); HARMSEL, Hendrik Willem ter, Everett, 98203 (US); TOM, Travis J., Everett, 98203 (US); AMES, Wilbur Russell, Everett, 98203 (US); FERRANTE, Joseph V., Everett, 98203 (US); BAKSHI, Ankur, Everett, 98203 (US); SCHUESSELE, Hans-Dieter, Everett, 98203 (US); ROSSI, Marco, Everett, 98203 (US)
(74) Representative: HGF

(57) **Abstract**

Methods, devices, and systems for automatically executing an electrical test application on a testing device based on user-selected cell in a table of electrical components and automatically updating the user-selected cell with a result of testing an electrical component that is associated with the user-selected cell. A user interface showing the table of electrical components to be tested is displayed such that a user input is received activating a target cell associated with an electrical component in the table. An electrical test application is identified based on the target cell and the electrical test application is automatically executed on the testing device to test the electrical component. A result of testing the electrical component is received. The result can optionally be populated into the target cell in the table and the user interface updated to show the table with the result populated in the target cell.

## Description

### BACKGROUND

### Technical Field

The present disclosure relates to testing electrical components, and more particularly to methods, devices, and systems in which an electrical test application is automatically selected and executed in response to a user selecting a cell in a table such that the cell is automatically updated with a result of testing an electrical component using the electrical test application.

### Description of the Related Art

When finalizing installation of electrical components in a fixed-wire installation, such as in a distribution board or circuit breaker of residential or commercial properties, technicians may test those electrical components to ensure they are safely installed. Proof of this testing often includes issuance of a completion certificate that lists test results and information about the installation. But testing the electrical components may include multiple different types of tests for multiple different types of electrical components. As a result, technicians generally manually track which tests are being performed on which electrical components, and then translating those results into the completion certificate. It is with respect to these and other considerations that the embodiments herein have been made.

### BRIEF SUMMARY

Briefly, embodiments are directed to methods, devices, and systems for automatically testing electrical components and storing their results. A user interface may be displayed to a user showing a table of electrical components to be tested. A user input is received, via the user interface, activating a target cell associated with an electrical component in the table. An electrical test application is identified based on the target cell. The electrical test application is automatically executed on a testing device to test the electrical component. A result of testing the electrical component is received from the electrical test application. And the target cell in the table is automatically populated with the result such that the user interface is updated showing the table of electrical components with the result populated in the target cell.

In some embodiments, an orientation of the testing device is determined. In response to determining that the orientation of the testing device is in a normal orientation, an electrical testing interface (e.g., the user interface of the table of electrical components to be tested or a user interface for the electrical test application) is displayed in the normal orientation on the testing device. A user input may be received via a directional physical input interface on the testing device. A normal directional action is then select based on the second user input, and selectable elements in the electrical testing interface are traversed based on the normal directional action. In response to determining that the orientation of the testing device is in a flipped orientation, the electrical testing interface is displayed in the flipped orientation on the testing device, wherein the flipped orientation is visually inverted on the testing device from the normal orientation. A user input may be received via the directional physical input interface on the testing device. And a flipped directional action is selected based on that user input and the testing device being in the flipped orientation. The selectable elements in the electrical testing interface are traverse based on the flipped directional action.

### BRIEF DESCRIPTION OF THE SEVERAL VIEWS OF THE DRAWINGS

Non-limiting and non-exhaustive embodiments are described with reference to the following drawings. In the drawings, like reference numerals refer to like parts throughout the various figures unless otherwise specified.

For a better understanding of the present invention, reference will be made to the following Detailed Description, which is to be read in association with the accompanying drawings:
Figures 1 and 2 illustrate context diagrams of devices and systems for automatically executing electrical test applications and storing their results in accordance with embodiments described herein;
Figure 3 illustrates a logical flow diagram showing one embodiment of a process for automatically executing an electrical test application and storing its results in accordance with embodiments described herein;
Figure 4 illustrates a logical flow diagram showing one embodiment of a process for automatically executing multiple electrical test applications and storing their results in accordance with embodiments described herein;
Figures 5A-5C illustrate an example embodiment of an electrical component testing device that automatically executes electrical test applications and stores their results in accordance with embodiments described herein;
Figures 6A-6C illustrate an example embodiment of a user device instructing an electrical component testing device to automatically executes electrical test applications and then storing their results in accordance with embodiments described herein;
Figures 7A-7C illustrate an example embodiment of a user device that automatically executes multiple electrical test applications on an electrical component testing device and stores their results in accordance with embodiments described herein;
Figure 8 illustrates a logical flow diagram showing one embodiment of a process for determining an orientation of an electrical component testing device and flipping actions associated with its physical inputs in accordance with embodiments described herein;
Figure 9 illustrates a logical flow diagram showing one embodiment of a process for determining a change in the orientation of an electrical component testing device and enabling a user to traverse cells in a table based on the changed orientation of the electrical component testing device in accordance with embodiments described herein; and
Figures 10A-10C illustrate an example embodiment of changing an orientation of an electrical component testing device in accordance with embodiments described herein;

### DETAILED DESCRIPTION

The following description, along with the accompanying drawings, sets forth certain specific details in order to provide a thorough understanding of various disclosed embodiments. However, one skilled in the relevant art will recognize that the disclosed embodiments may be practiced in various combinations, without one or more of these specific details, or with other methods, components, devices, materials, etc. In other instances, well-known structures or components that are associated with the environment of the present disclosure, including but not limited to the communication systems and networks, have not been shown or described in order to avoid unnecessarily obscuring descriptions of the embodiments. Additionally, the various embodiments may be methods, systems, media, or devices. Accordingly, the various embodiments may be entirely hardware embodiments, entirely software embodiments, or embodiments combining software and hardware aspects.

Throughout the specification, claims, and drawings, the following terms take the meaning explicitly associated herein, unless the context clearly dictates otherwise. The term "herein" refers to the specification, claims, and drawings associated with the current application. The phrases "in one embodiment," "in another embodiment," "in various embodiments," "in some embodiments," "in other embodiments," and other variations thereof refer to one or more features, structures, functions, limitations, actions, or characteristics of the present disclosure, and are not limited to the same or different embodiments unless the context clearly dictates otherwise. Furthermore, the described features, structures, functions, limitations, actions, or characteristics may be combined in any suitable manner in accordance with this disclosure, and references to "in one embodiment," "in another embodiment," "in various embodiments," "in some embodiments," "in other embodiments," etc., do not preclude the combination of the features, structures, functions, limitations, actions, or characteristics in any of the embodiments described herein. Accordingly, embodiments described herein can be combined in any combination unless the context clearly dictates otherwise.

For the purposes of the present disclosure, unless otherwise indicated, the phrase "A and B" is nonlimiting and means one or more of (A) and one or more of (B); the phrase "A or B" is nonexclusive and means one or more of (A), one or more of (B), or one or more of (A and B); the phrase "A and/or B" means one or more of (A), one or more of (B), or one or more of (A and B); the phrase "at least one of A and B" and the phrase "one or more of A and B" both mean one or more of (A) and one or more of (B); and the phrase "at least one of A or B" and the phrase "one or more of A or B" both mean one or more of (A), one or more of (B), or one or more of (A and B). By way of extension, for example, the phrases "at least one of A, B, or C" and "one or more of A, B, or C" both mean one or more of (A), one or more of (B), one or more of (C), one or more of (A and B), one or more of (A and C), one or more of (B and C), or one or more of (A, B and C). In the above, A, B, and C represent any form or type of element, feature, arrangement, component, structure, aspect, action, step, etc.

In fixed wire installations, such as to provide electrical power to commercial or residential properties, technicians install numerous electrical components in circuit breakers or distribution boards. In some regions, such as in Europe, the safety features of the electrical components need to be tested and their safety certified. As proof of this testing, a completion certificate must be issued, which includes test results and information about the installation. Currently, technicians manually add the test results and installation information to the certificate. In some situations, technicians can transfer test results from an installation tester to specific certification software during or after testing, which is time consuming and is prone to errors.

Described herein is a solution that automates the testing of electrical components and the storing of results. For example, a user interface is displayed to a user showing a table of electrical components that are to be tested. Cells in the table correspond to specific combinations of an electrical component and an electrical test to implement on that electrical component. The user can activate a target cell in the table, which causes an electrical test application to execute on a testing device to test the electrical component associated with the target cell in accordance with the electrical test associated with that target cell. A result of testing the electrical component is received from the electrical test application. In some situations, the results may be populated into the target cell in response to receiving the result from the electrical test application.

Moreover, when a technician performs an installation test at a circuit breaker or distribution board, the technician traditionally wears the testing device (also referred to as an installation tester) around their neck via a strap. In this way, the technician can look down to read a display on the testing device. The position of the testing device also causes the sockets, in which testing leads can be connected to perform an electrical test on an electrical component, to face away from the technician and towards the circuit breaker or distribution board. Unfortunately, the testing device, or the testing leads, can get in the way and in some cases present a danger during testing. Thus, it may be advantageous to hang the testing device by the strap and away from the technician (i.e., the strap is not around the technician's neck). But if the testing device is being hung by the strap, and not around the technician's neck, then the display and the physical input interfaces on the testing device are inverted from the technician's perspective, which can make it difficult for the technician to use the testing device.

Described herein is a solution that flips operation of the testing device when in a flipped orientation, such as when the testing device is being hung by the strap and away from the user. In some situations, an inertial sensor can be used to determine the orientation of the testing device, i.e., whether the testing device is in a normal orientation or in a flipped orientation. In other situations, the user can toggle a setting that defines the orientation of the testing device. If the testing device is in the normal orientation, then a graphical user interface is displayed as expected and actions performed via inputs to the physical input interfaces operate as expected. But if the testing device is in the flipped orientation, then the graphical user interface is visually inverted and the actions performed via inputs to the physical input interfaces become flipped. For example, a button that operates an "up" command when the testing device is in the normal orientation will operate as a "down" command when the testing device is in the flipped orientation. Therefore, the user interface and the physical input interfaces operate as expected from the perspective of the user, even though the testing device is in a flipped orientation.

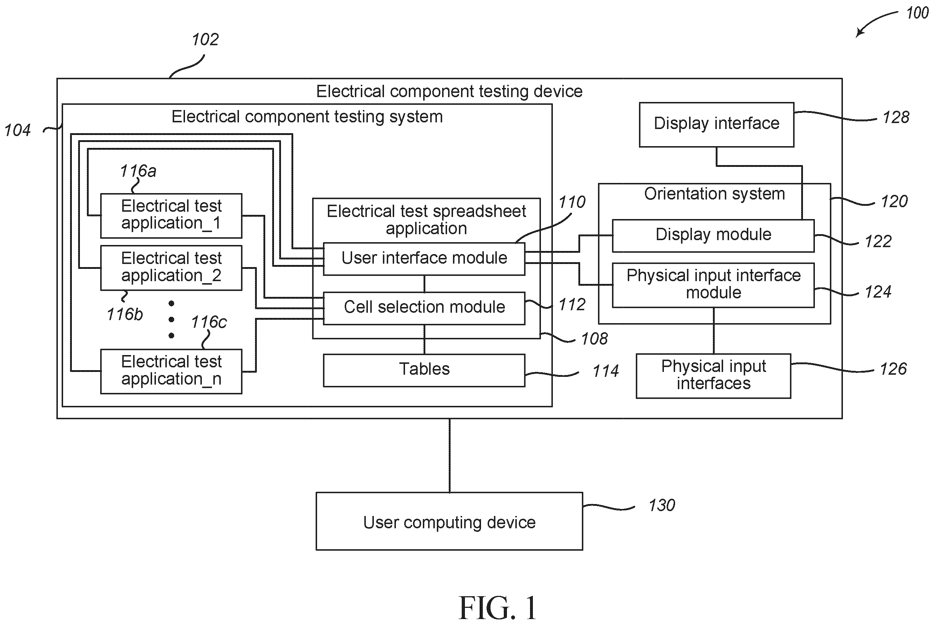

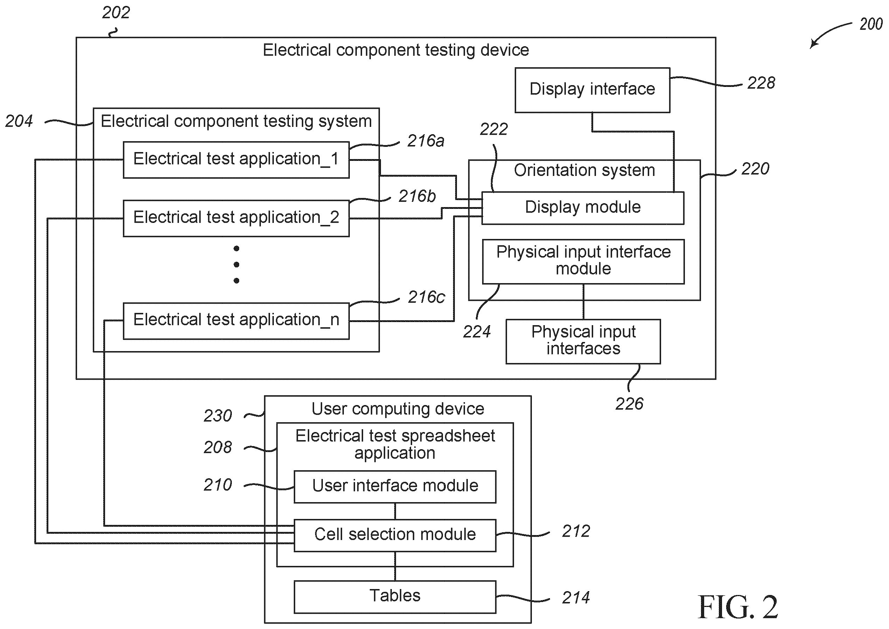

Figures 1 and 2 illustrate context diagrams of devices and systems for automatically executing electrical test applications and storing their results in accordance with embodiments described herein.

Figure 1 illustrates a context diagram a system 100 for automatically executing electrical test applications and storing their results in accordance with embodiments described herein. System 100 includes an electrical component testing device 102 and a user computing device 130. In some embodiments, user computing device 130 may be optional and may not be included in system 100.

Electrical component testing device 102 includes an electrical component testing system 104, an orientation system 120, a display interface 128, and physical input interfaces 126.

The display interface 128 is configured to output user interfaces via a display device (not shown). Such a display device may include, but are not limited to, LCD screens, LEDs or other lights, or other types of display devices. In various embodiments, the display device may be integrated as part of the electrical component testing device 102.

The physical input interfaces 126 are configured to receive physical inputs from a user of the electrical component testing device 102. Examples of the physical input interfaces may include, but are not limited to, a rotary input interface, up/down (or vertical) buttons, left/right (or horizontal) buttons, up/down (or vertical) scroll wheel, left/right (or horizontal) scroll wheel, multi-directional touchpoint button, rotary encoder, rotary knobs, jog dial, jog wheel, shuttle dial, shuttle wheel, or other physical input interfaces.

The electrical component testing system 104 is configured to display a table of electrical components to be tested to a user, automatically execute an electrical test application to test an electrical component in response to the user activating a cell, and automatically update the cell in the table with a result of the electrical test application testing the electrical component. In some embodiments, the electrical component testing system 104 may also be configured to generate a certification or report of the electrical components that were tested and the results of those tests.

In general, electrical component testing system 104 includes one or more electrical test applications 116a-116c, an electrical test spreadsheet application 108, and tables 114. The electrical test applications 116a-116c are configured to perform separate electrical tests on electrical components when executed. In some embodiments, the electrical test applications 116a-116c may output corresponding user interfaces that enable a user to execute the corresponding electrical test.

Tables 114 stores one or more tables that list electrical components that are to be tested. In some embodiments, each separate table stored by tables 114 may be for a separate residential or commercial property or for a separate distribution board or circuit breaker. Each table includes a plurality of cells situated in a plurality of rows and a plurality of columns. Each cell in the table corresponds to a particular electrical component and a particular electrical test that is to be performed on that particular electrical component. In some embodiments, the table may also store metadata describing the electrical components or the electrical tests, or a combination thereof. For example, the metadata may include the name of the electrical component, the type of electrical component, a sequence of a plurality of auto-tests for the electrical component, a room or electrical device connected to the electrical component, a site (e.g., a residential or commercial address) where the electrical component is installed, the name of the electrical test, one or more acceptable test result values or ranges for one or more types of electrical components, which electrical test to perform next, information regarding how the electrical test is to be performed (e.g., which leads to use or where to connect the leads), etc. The electrical components may be any type of circuit or residual-current device (RCD) (also referred to as a residual-current circuit breaker (RCCB) or a ground fault circuit interrupter (GFCI)) that may be installed in a distribution board or circuit breaker of a residential or commercial property. And the electrical tests may test those electrical components for voltage, current, resistance, insulation, continuity, residual-current device trip level, residual-current device trip time, residual-current device trip (e.g., did the residual-current device trip or not in response to a specific electrical simulant), or other appropriate electrical properties or characteristics.

Electrical test spreadsheet application 108 includes a user interface module 110 and a cell selection module 112. In some embodiments, the user interface module 110 is configured to output or display graphical user interfaces to a user using display module 122 of the orientation system 120 and to receive user inputs from physical input interface module 124 of the orientation system 120. In other embodiments, the user interface module 110 may be configured to directly output or display graphical user interfaces to a user via display interface 128 and to receive user inputs via physical input interfaces 126 without the orientation system 120. Moreover, the user interface module 110 may be configured to receive other user inputs via other interfaces (not shown). For example, the display interface 128 may be a touchscreen interface that enables a user to select cells or graphical buttons that are being displayed.

The cell selection module 112 is configured to access a table stored by tables 114 and display that table to a user via the user interface module 110. The cell selection module 112 may receive a user input via that user interface module 110 identifying a cell in the table that the user has activated or selected. The cell selection module 112 then identifies the electrical component and the electrical test to perform on that electrical component based on the activated cell. At least one technical effect of activating a target cell includes the automatic execution of the correct electrical test application on the electrical component testing device. In this way, the user can determine which electrical component to test, while the system automatically and efficiently selects and executes the correct electrical test application. The cell selection module 112 automatically executes the electrical test application 116a-116c that corresponds to the electrical test that corresponds to the activated cell. In some embodiments, the cell selection module 112 may automatically execute a plurality of electrical test applications 116a-116c in response to the user activating an auto-test that identifies a plurality of ordered electrical tests that are to be performed on an electrical component. When executed the electrical test applications 116a-116c may output a user interface to the user via the user interface module 110, which enables the user to test the electrical component that corresponds to the activated cell. Upon completion of the testing of the electrical component, the electrical test application provides the results of the testing to the cell selection module 112. And the cell selection module 112 automatically updates the cell (or cells) in the table stored in tables 114 with the results. At least one technical effect of automatically populating the result in the target cell and updating the table includes the automatic generation of information needed to create the certification for the electrical components being tested. Moreover, the user can quickly and easily determine which electrical components have been tested, which electrical components have not been tested, and the results of those tests.

The electrical component testing device 102 may also include an orientation system 120, which includes a display module 122 and a physical input interface module 124. In some embodiments, orientation system 120 may be optional and may not be included in the electrical component testing device 102.

The orientation system 120 is configured to determine a current orientation of the electrical component testing device 102. In some embodiments, the current orientation may be a normal orientation or a flipped orientation. The display module 122 is configured to receive user interfaces of tables or electrical test applications from the user interface module 110 and then output or display those user interfaces via the display interface 128 based on the current orientation. Therefore, if the electrical component testing device 102 is in a normal orientation, then the display module 122 outputs or displays user interfaces in their normal orientation. But if the electrical component testing device 102 is in a flipped orientation, then the display module 122 outputs or displays user interfaces in a flipped orientation.

The physical input interface module 124 enable the user to provide input via the physical input interfaces 126 in accordance with the current orientation of the electrical component testing device 102 such that the user can utilize the electrical component testing device 102 in a manner consistent with its normal operations. Therefore, if the electrical component testing device 102 is in a normal orientation, then user inputs via the physical input interfaces 126 are converted into normal directional actions based on their normal orientation operations. For example, an up button would move a cursor or selectable icon in an up direction on a table being displayed. But if the electrical component testing device 102 is in a flipped orientation, then user inputs via the physical input interfaces 126 are converted into flipped directional actions that are opposite of their normal orientation operations. The physical input interface 126 may operate as software or firmware to convert the physical inputs into the normal or flipped directional actions based on the current orientation of the electrical component testing device 102. For example, an up button would move a cursor or selectable icon in a down direction on a table being displayed. In this way, even though the electrical component testing device 102 is flipped, the table being displayed would look correct to a user and the physical user inputs would operate in a same manner as the user would normally expect. At least one technical effect of selecting a flipped directional action for the user input based on the electrical component testing device being in the flipped orientation includes the automatic flipping or reversal of the user inputs on the electrical component testing device to enable the user to use the electrical component testing device as if it is in the normal orientation, even though it is in the flipped orientation.

In some embodiments, the user computing device 130 may be configured to generate the initial tables that identify each electrical component to be tested and the electrical tests that are to be performed on those electrical components. In other embodiments, the user computing device 130 may be configured to receive the updated table, or the certifications generated from the tables, after completion of the electrical tests are performed. In at least one embodiment, the user computing device 130 may be configured to generate the certifications from the updated tables. In various embodiments, the user computing device 130 may communicate with the electrical component testing device 102 via Bluetooth, USB-C, WiFi, or other wired or wireless communication interface.

Figure 2 illustrates a context diagram a system 200 for automatically executing electrical test applications and storing their results in accordance with embodiments described herein. System 200 includes an electrical component testing device 202 and a user computing device 230. System 200 performs functionality similar to system 100 in Figure 1, but with some functions being performed on the electrical component testing device 202 and other functions being performed on the user computing device 230.

Electrical component testing device 202 includes an electrical component testing system 204, an orientation system 220, a display interface 228, and physical input interfaces 226.

The display interface 228 is configured to output user interfaces via a display device (not shown), and the physical input interfaces 226 are configured to receive physical inputs from a user of the electrical component testing device 202. The display interface 228 and the physical input interfaces 226 may employ embodiments of the display interface 128 and the physical input interfaces 126 in Figure 1, respectively.

The electrical component testing system 204 is configured to execute electrical test applications 216a-216c to perform electrical tests on electrical components in response to commands or messages received from the user computing device 230 and to transmit results from those tests to the user computing device 230. In some embodiments, the electrical test applications 216a-216c may output corresponding user interfaces that enable a user to execute the corresponding electrical test.

The orientation system 220 is configured to determine a current orientation (e.g., a normal orientation or a flipped orientation) of the electrical component testing device 202 similar to the orientation system 120 in Figure 1. The orientation system 220 similarly includes a display module 222 and a physical input interface module 224. The physical input interface module 224 may employ embodiments similar to the physical input interface module 124 in Figure 1 to enable the user to provide input via the physical input interfaces 226 in accordance with the current orientation of the electrical component testing device 202 such that the user can utilize the electrical component testing device 202 in a manner consistent with its normal operations. And the display module 222 may employ embodiments similar to the display module 122 in Figure 1 to display user interfaces based on the current orientation of the electrical component testing device 202. In some embodiments, orientation system 220 may be optional and may not be included in the electrical component testing device 202.

The user computing device 230 includes an electrical test spreadsheet application 208 and tables 214. The tables 214 may store one or more tables similar to the tables stored by tables 114 in Figure 1. The electrical test spreadsheet application 208 is configured to display a table of electrical components to be tested to a user, instruct or command the electrical component testing device 202 to automatically execute electrical test applications to perform tests on an electrical component, and automatically update the cell in the table with a result of the electrical test application testing the electrical component received from the electrical component testing device 202. In some embodiments, the electrical test spreadsheet application 208 may also be configured to generate a certification or report of the electrical components that were tested and the results of those tests.

Electrical test spreadsheet application 208 includes a user interface module 210 and a cell selection module 212 similar to the electrical test spreadsheet application 108 in Figure 1. The user interface module 210 is configured to output or display graphical user interfaces of the tables on the user computing device and to receive user activations or selections of cells in the tables.

The cell selection module 212 is configured to access a table stored by tables 214 and display that table to a user via the user interface module 210. The cell selection module 212 may receive a user input via that user interface module 210 identifying a cell in the table that the user has activated or selected. The cell selection module 212 then identifies the electrical component and the electrical test to perform on that electrical component based on the activated cell. The cell selection module 212 commands, instructs, or otherwise transmits a message to the electrical component testing system 204 of the electrical component testing device 202 such that the electrical component testing system 204 automatically executes the electrical test application 216a-216c that corresponds to the electrical test that corresponds to the activated cell. In some embodiments, the cell selection module 212 may command the electrical component testing device 202 to perform a plurality of sequential electrical test applications 216a-216c in response to the user activating an auto-test that identifies a plurality of ordered electrical tests that are to be performed on an electrical component. Upon completion of the testing of the electrical component, the cell selection module 212 receives results of the testing from the electrical test application 216. And the cell selection module 212 automatically updates the cell (or cells) in the table stored in tables 214 with the results. In this way, the user computing device 230 handles the functionality of displaying and updating the tables and the electrical component testing device 202 handles the functionality of performing the electrical tests on the electrical components.

For ease of illustration, all of the computing components of the electrical component testing device 102 in Figure 1, the user computing device 130 in Figure 1, the electrical component testing device 202 in Figure 2, and the user computing device 230 in Figure 2 are not shown. But one or more special-purpose computing systems may be used to implement each of these devices. Accordingly, various embodiments described herein may be implemented in software, hardware, firmware, or in some combination thereof. Moreover, each of these devices includes memory, a processor system, I/O interfaces, other computer-readable media, and network connections.

The processor system of one or more of these devices includes one or more processors, one or more processing units, programmable logic, circuitry, or one or more other computing components that are configured to perform embodiments described herein or to execute computer instructions to perform embodiments described herein. In some embodiments, the processor system may include a single processor that operates individually to perform actions. In other embodiments, the processor system may include a plurality of processors that operate to collectively perform actions, such that one or more processors may operate to perform some, but not all, of such actions. Reference herein to "a processor system" refers to one or more processors that individually or collectively perform actions. And reference herein to "the processor system" refers to I) a subset or all of the one or more processors comprised by "a processor system" and 2) any combination of the one or more processors comprised by "a processor system" and one or more other processors.

The memory of one or more of these devices may include one or more various types of non-volatile and/or volatile storage technologies. Examples of such memory may include, but are not limited to, flash memory, hard disk drives, optical drives, solid-state drives, various types of random access memory (RAM), various types of read-only memory (ROM), other computer-readable storage media (also referred to as processor-readable storage media), or the like, or any combination thereof. The memory may be utilized to store information, including computer-readable instructions that are utilized by a processor system to perform actions, including embodiments described herein.

The network connections of one or more of these devices are configured to communicate with various computing devices and include transmitters and receivers (not illustrated) to send and receive data as described herein. The I/O interfaces of one or more of these devices may include one or more data input or output interfaces, video or display interfaces, or other input/output interfaces. And the other computer-readable media of one or more of these devices may include other types of stationary or removable computer-readable media, such as removable flash drives, external hard drives, or the like.

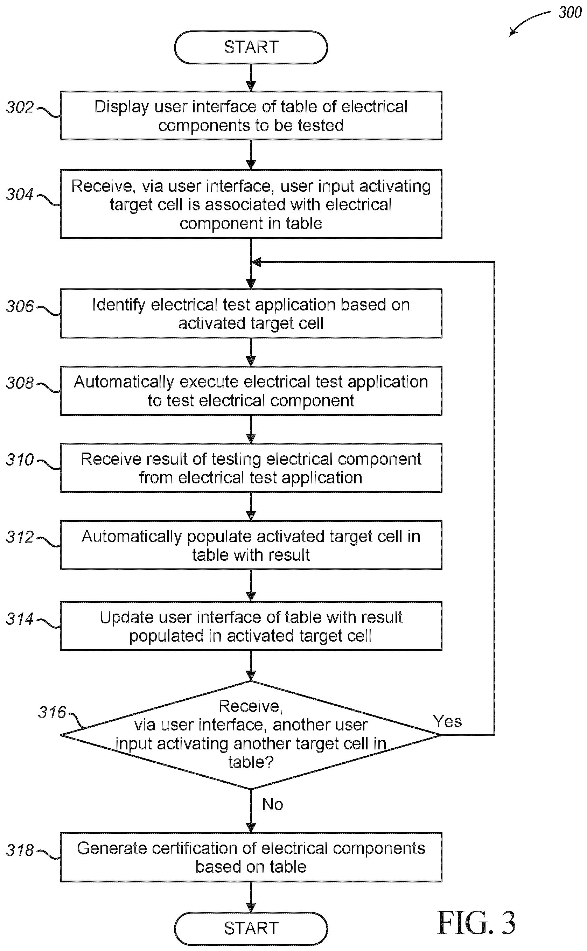

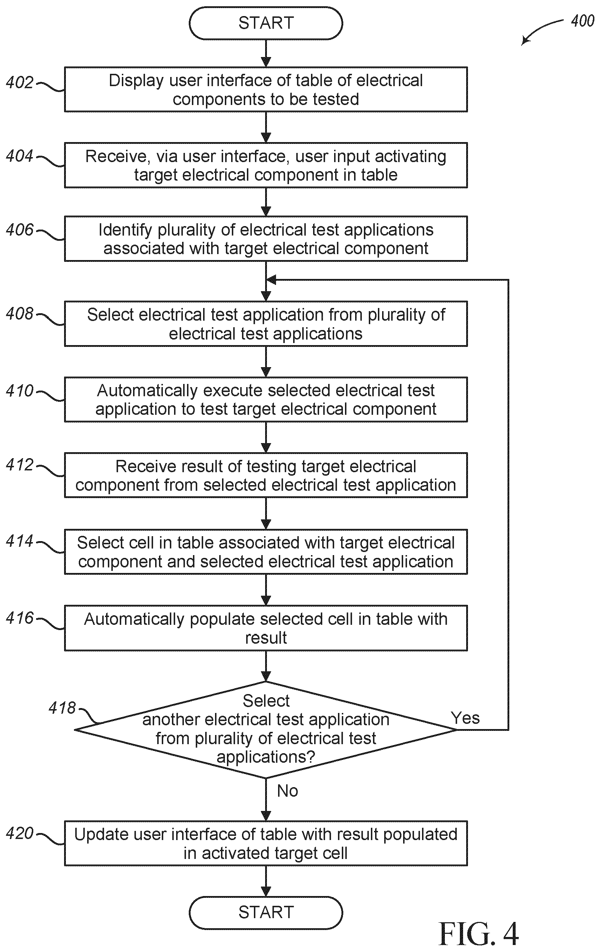

The operation of certain aspects will now be described with respect to Figures 3, 4, 5A-5C, 6A-6C, and 7A-7C. In at least one of various embodiments, processes 300 and 400 described in conjunction with Figures 3 and 4, respectively, may be implemented by or executed via circuitry or on one or more computing devices, such as electrical component testing device 102 in Figure 1, user computing device 230 in Figure 2, or a combination of electrical component testing device 202 and user computing device 230 in Figure 2.

Figure 3 illustrates a logical flow diagram showing one embodiment of a process 300 for automatically executing an electrical test application and storing its results in accordance with embodiments described herein.

Process 300 begins, after a start block, at block 302, where a user interface of a table of electrical components to be tested is displayed to a user. Each cell in the table corresponds to a particular electrical component and a particular electrical test that is to be performed on that particular electrical component. In some embodiments, each row corresponds to a separate electrical component that is to be tested, and each column corresponds to a particular electrical test. In other embodiments, each column corresponds to a separate electrical component that is to be tested, and each row corresponds to a particular electrical test.

In various embodiments, the table includes metadata describing the electrical components or the electrical tests, or a combination thereof. Each row may include metadata describing the electrical component of that row, which may be referred to as electrical component information. This metadata may include the name of the electrical component, the type of electrical component, a sequence of a plurality of auto-tests for the electrical component, a room or electrical device connected to the electrical component, a site (e.g., a residential or commercial address) where the electrical component is installed, etc. Similarly, each column may include metadata describing the electrical test of that column, which may be referred to as electrical test information. This metadata may include the name of the electrical test, one or more acceptable test result values or ranges for one or more types of electrical components, which electrical test to perform next, information regarding how the electrical test is to be performed (e.g., which leads to use or where to connect the leads), etc. In some embodiments, the metadata may be stored for each individual cell, rather than for the rows or columns. Accordingly, each corresponding cell may include metadata describing the electrical component information and the electrical test information for that corresponding cell.

In some situations, a particular electrical test may not be applicable for a particular type of electrical component. Accordingly, some cells in the table may be considered as null where the corresponding electrical test would be inapplicable for the corresponding electrical component for that cell.

Process 300 proceeds, after block 302, to block 304, where a user input activating or selecting a target cell in the table of electrical components is received via the user interface. Accordingly, the target cell corresponds to a particular row and a particular column in the table. In this way, the particular row for the target cell corresponds to the electrical component that is to be tested and the particular column for the target cell corresponds to the particular electrical test to perform on the electrical component. In some other embodiments, the particular column for the target cell corresponds to the electrical component that is to be tested and the particular row for the target cell corresponds to a particular electrical test to perform on the electrical component.

Process 300 continues, after block 304, at block 306, where an electrical test application is identified based on the target cell that is activated or selected by the user. Because the target cell corresponds to a particular electrical component and a particular electrical test that is to be performed on that particular electrical component, the electrical test application is the program, interface, or function that performs the particular electrical test associated with the target cell. As discussed herein, the electrical test application may perform an electrical test of voltage, current, resistance, insulation, continuity, residual-current device trip level, residual-current device trip time, residual-current device trip (e.g., did the residual-current device trip or not in response to a specific electrical simulant), or other electrical tests.

Process 300 proceeds, after block 306, to block 308, where the electrical test application identified at block 306 is automatically executed to test the electrical component associated with the activated target cell.

In some embodiments, where the electrical component testing device is performing process 300, the electrical component testing device automatically executes the electrical test application. In other embodiments, where the user device is performing process 300, then the user device transmits a command or message to the electrical component testing device instructing the electrical component testing device to execute the electrical test application on the electrical component testing device. Once the electrical component testing device receives the command or message from the user device, the electrical component testing device automatically executes the electrical test application.

In some embodiments, the electrical test application may automatically begin testing the electrical component upon execution. In other embodiments, initiate execution of the electrical test application and then await user input to begin testing the electrical component. In various embodiments, the electrical test application provides a user interface (also referred to as an electrical testing interface) to the user of the electrical component testing device. In at least one embodiment, the user interface provides directions to the user identifying the electrical component that is to be tested and how to test that electrical component (e.g., which leads to use and where to position the leads to properly test the electrical component).

Process 300 continues, after block 308, at block 310, where a result of testing the electrical component is received from the electrical test application. In some embodiment, the user may activate or select a button in the user interface of the electrical test application to trigger the result being received or captured.

In some embodiments, where the electrical component testing device is performing process 300, the electrical component testing device receives the result from the electrical test application and stores the result for later use. In other embodiments, where the user device is performing process 300, the user device receives the result from the electrical component testing device and stores the result for later use.

Process 300 proceeds, after block 310, to block 312, where the target cell in the table is automatically populated with the result. In various embodiments, the value of the electrical test result is stored in the target cell in the table. In some embodiments, the formatting of the target cell may be modified based on a comparison between the result and limits, ratings, or pass/fail conditions for the electrical component or the electrical test. For example, if the result is within an expected range of values for the electrical test associated with the target cell, then the target cell may be highlighted in green. But if the result is outside the expected range of values for the electrical test associated with the target cell, then the target cell may be highlighted in red. Similarly, if the result is zero or some other error value for the electrical test associated with the target cell, then the target cell may be modified to indicate the null or error result (e.g., by including the word "error" in the target cell). In some embodiments, block 312 may be optional and may not be performed.

Process 300 continues, after block 312, at block 314, where the user interface is updated to show the table with the result being populated in the target cell. In some embodiments, only the result populated in the target cell is updated in the user interface. In other embodiments, a next target cell may be highlighted on in the table (or a visual cue may be displayed over the table) identifying the next electrical component and electrical test for the user to activate or select. In some embodiments, block 314 may be optional and may not be performed.

Process 300 proceeds, after block 314, to decision block 316, where a determination is made whether another user input is received activating or selecting another target cell in the table. In various embodiments, the user can activate a first target cell of an electrical component in the table and then activate a second target cell after the result of testing the electrical component has been populated in the first target cell. In some situations, the second target cell may be another cell in the table associated with the same electrical component as the first target cell. In other situations, the second target cell may be associated with the separate electrical component in the table.

If the user does not activate another target cell in the table, or if the user selects a done or completion button, then process 300 flows to block 318. But if the user activates another target cell in the table, then process 300 loops to block 306 to identify and automatically execute an electrical test application for the other activated target cell and automatically populate the other activated target cell with the result of that test. In some embodiments, block 316 may be optional and may not be performed.

At block 318, a certification is generated for the electrical components in the table based on the information and results stored in the table. As mentioned herein, the table may include metadata describing the electrical components or the electrical tests, or both. Accordingly, the certification can be generated to include a list of each electrical component in the table, the electrical tests that were performed on those electrical components, and the results of those tests. In some embodiments, block 318 may be optional and may not be performed.

After block 318, process 300 terminates or otherwise returns to a calling process to perform other actions.

Figure 4 illustrates a logical flow diagram showing one embodiment of a process 400 for automatically executing multiple electrical test applications and storing their results in accordance with embodiments described herein.

Process 400 begins, after a start block, at block 402, where a user interface of a table of electrical components to be tested is displayed to a user. In various embodiments, block 402 may employ embodiments of block 302 in Figure 3 to display the user interface of the table of electrical components.

Process 400 proceeds, after block 402, to block 404, where a user input activating or selecting of a target electrical component in the table is received via the user interface. In some embodiments, the user may activate or select a cell that identifies the target electrical component. In other embodiments, the user may activate or select a row (or column), an icon, button, or other selectable element that corresponds to the target electrical component.

Process 400 continues, after block 404, at block 406, where a plurality of electrical test applications are identified or determined based on the target electrical component. The plurality of electrical test applications may be determined from an auto-test that comprises a sequence of a plurality of electrical tests. In some embodiments, the system may store one or a plurality of default or user-generated auto-tests. In some embodiments, one or more of the auto-tests may be generated for all electrical components in the table, generated for a sub-set (but not all) of the electrical components in the table, generated for a specific type of electrical component, or generated for a specific electrical component.

In some embodiments, the user may generate one or more auto-tests by selecting which electrical tests are to be performed and the order in which those electrical tests are to be performed. In other embodiments, the user may modify one or more default or user-generated auto-tests, such as by changing one or more electrical tests in the auto-test or changing the order of one or more electrical tests in the auto-test.

Process 400 proceeds, after block 406, to block 408, where an electrical test application is selected from the plurality of electrical test applications identified at block 406. In some embodiments, the plurality of electrical test applications may include a predetermined or selected order in which the electrical test applications are to be selected. As such, the electrical test application that is first in the order is initially selected, followed by subsequently ordered electrical test applications as process 400 loops through the plurality of electrical test applications.

Process 400 continues, after block 408, at block 410, where the selected electrical test application is automatically executed to test the target electrical component. In various embodiments, block 410 may employ embodiments of block 308 in Figure 3 to automatically execute the selected electrical test application.

Process 400 proceeds, after block 410, to block 412, where a result of testing the target electrical component is received from the selected electrical test application. In various embodiments, block 412 may employ embodiments of block 310 in Figure 3 to receive the result of the electrical test. In some embodiments, block 412 may be optional and may not be performed.

Process 400 continues, after block 412, at block 414, where a cell in the table is selected based on the target electrical component and the selected electrical test application. For example, if the selected electrical test application is to test the voltage of the target electrical component, then the selected cell is positioned at the column associated with the voltage test and the row is associated with the target electrical component. In some embodiments, block 414 may be optional and may not be performed.

Process 400 proceeds, after block 414, to block 416, where the selected cell in the table is automatically populated with the result. In various embodiments, block 416 may employ embodiments of block 312 in Figure 3 to automatically populate the selected cell with the result. In some embodiments, block 416 may be optional and may not be performed.

Process 400 continues, after block 416, at decision block 418, where a determination is made whether another electrical test application is selected from the plurality of electrical test applications identified at block 406. As mentioned above, the plurality of electrical test applications may be in a predetermined order. If there is a next electrical test application in the order, then another electrical test is to be selected. If another electrical test application is to be selected, then process 400 loops to block 408 to select another electrical test application; otherwise, process 400 flows to block 420. In some embodiments, block 418 may be optional and may not be performed.

At block 420, the user interface is updated to show the table with the automatically populated results from executing the plurality of electrical test applications to test the target electrical component. In various embodiments, block 420 may employ embodiments of block 314 in Figure 3 to update the user interface. In some embodiments, block 420 may be optional and may not be performed.

Although Figure 4 illustrates updating the user interface after the plurality of electrical test applications are selected and automatically executed, embodiments are not so limited. In some embodiments, the user interface may be updated after each result is automatically populated in the table at block 416.

After block 420, process 400 terminates or otherwise returns to a calling process to perform other actions. In some embodiments, a user may activate another target electrical component to have an auto-test performed on another target electrical component, in which case process 400 loops to block 404 to receive the user input activating another target electrical component in the table. In other embodiments, a user may activate a target cell in the table, in which case process 300 may be performed starting at block 304 to receive the user input activating a target cell in the table.

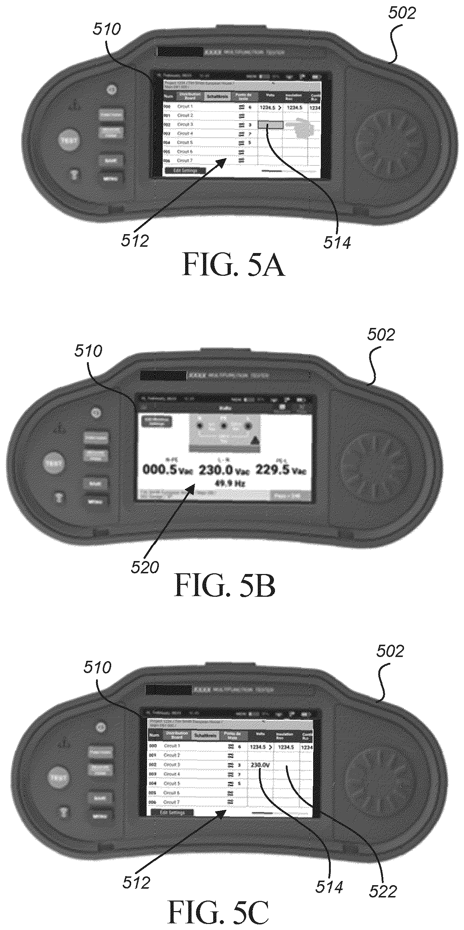

Figures 5A-5C illustrate an example embodiment of an electrical component testing device 502 that automatically executes electrical test applications and stores their results in accordance with embodiments described herein. In various embodiments, electrical component testing device 502 is an embodiment of electrical component testing device 102 in Figure 1.

Starting with Figure 5A and as described herein, the electrical component testing device 502 displays or present a user interface of a table 512 to a user via a display device 510. Each row in the table 512 corresponds to a separate electrical component that is to be tested, and various columns in the table 512 correspond to separate electrical tests to be performed. A user can activate or select target cell 514, such as by tapping on the display device 510 or using one or more physical user input interfaces on the electrical component testing device 502 to traverse the cells and select target cell 514.

In response the user activating target cell 514, an electrical test application 520 is automatically identified and executed based on the electrical test associated with the target cell 514. In some embodiments, a user interface for the electrical test application 520 is displayed on the display device 510 of the electrical component testing device 502, which is shown in Figure 5B.

In response to the electrical test application 520 testing an electrical component, the target cell 514 is automatically updated in the table 512 with a result of the testing, which is shown in Figure 5C. In some embodiments, the user can then select cell 522 to automatically identify and execute another electrical test application based on the electrical test associated with the cell 522.

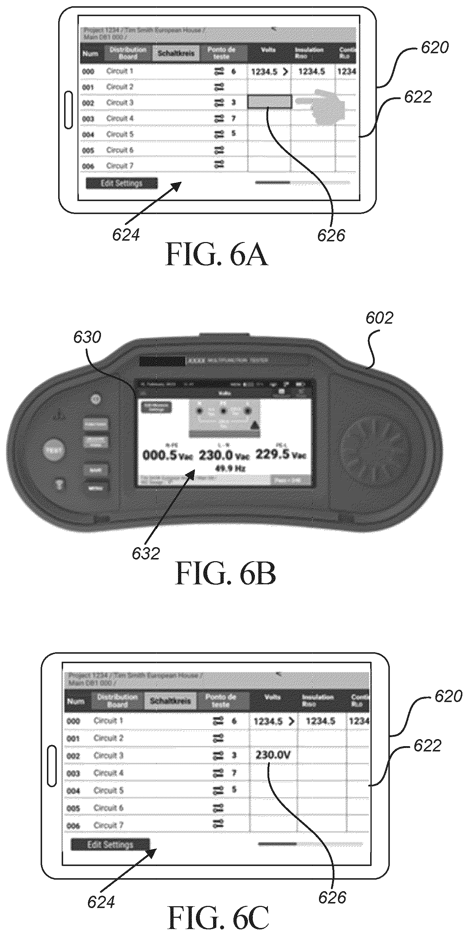

Figures 6A-6C illustrate an example embodiment of a user device 620 instructing an electrical component testing device 602 to automatically executes electrical test applications and then storing their results in accordance with embodiments described herein. In various embodiments, user device 620 is an embodiment of user computing device 230 in Figure 2 and electrical component testing device 602 is an embodiment of electrical component testing device 202 in Figure 2.

Starting with Figure 6A and as described herein, the user device 620 displays or present a user interface of a table 624 to a user via a display device 622. Each row in the table 624 corresponds to a separate electrical component that is to be tested, and various columns in the table 624 correspond to separate electrical tests to be performed. A user can activate or select target cell 626, such as by tapping on the display device 622.

In response the user activating target cell 626, an electrical test application 632 is automatically identified based on the electrical test associated with the target cell 626. The user device 620 then sends a message or command to the electrical component testing device 602 to automatically execute the electrical test application 632. A user interface for the electrical test application 632 is displayed on a display device 630 of the electrical component testing device 602, which is shown in Figure 6B. In various embodiments, electrical test application 632 may be similar to the electrical test application 520 in Figure 5B.

In response to the electrical test application 632 testing an electrical component, the electrical component testing device 602 sends or transmits a result of the testing to the user device 620. The target cell 626 is automatically updated in the table 624 being displayed on the user device 620, which is shown in Figure 6C.

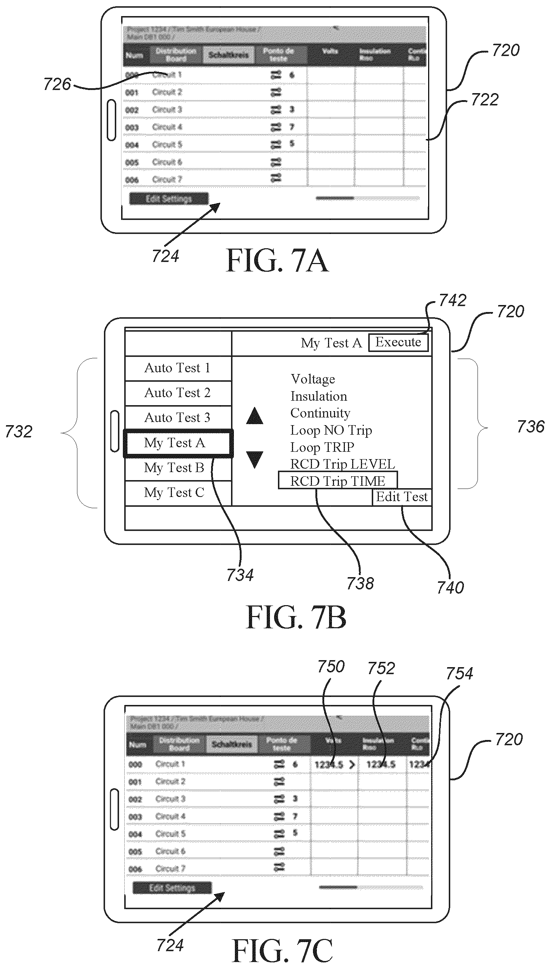

Figures 7A-7C illustrate an example embodiment of a user device 720 that automatically executes multiple electrical test applications on an electrical component testing device and stores their results in accordance with embodiments described herein. In various embodiments, user device 720 may be an embodiment of user computing device 230 in Figure 2.

Starting with Figure 7A and as described herein, the user device 720 displays or present a user interface of a table 724 to a user via a display device 722. Each row in the table 724 corresponds to a separate electrical component that is to be tested, and various columns in the table 724 correspond to separate electrical tests to be performed. A user can activate or select target electrical component 726, such as by tapping on the display device 722.

In response the user activating target electrical component 726, a plurality of electrical test applications are automatically identified based on the target electrical component 726. In some embodiments, the user may be presented with a plurality of auto-tests that are available to be performed on the target electrical component 726, which is which is shown in Figure 7B.

As shown in Figure 7B, user device 720 can display a plurality of auto-tests 732. Each auto-test may include a plurality of ordered electrical tests. For example, a user can select auto-test 734, which displays a plurality of electrical tests 736. In this illustration, the plurality of electrical tests 736 are shown as a list in the order in which they are to be performed, with the first electrical test to be performed being on the top of the list and the last electrical test to be performed on the bottom of the test. In various embodiments, the user can edit or modify the auto-test 734. For example, the user can select electrical test 738 to change the order in which it is performed with the other electrical tests. Or the user can select button 740 to further edit the electrical test, such as to delete the electrical test, modify pass/fail parameters, etc.

In response to the user activating the target electrical component 726 in Figure 7A or activating button 742 in Figure 7B, the user device 720 then sends a message or command to an electrical component testing device to automatically execute the plurality of electrical tests 736 of the auto-test 734. In some embodiments, the user device 720 may send a single command or message to the electrical component testing device identifying each electrical test application and the order in which they are executed. In other embodiments, the user device 720 may send a separate command or message to the electrical component testing device for each separate electrical test application to be executed. In some embodiments, the electrical component testing device may display one or more user interfaces for the plurality of electrical test applications to be executed, such shown in Figure 6B.

In response to the plurality of electrical test applications testing an electrical component, the electrical component testing device sends or transmits the results of the testing to the user device 720. The cells 750, 752, and 754 are automatically updated in the table 724 being displayed on the user device 720, which is shown in Figure 7C.

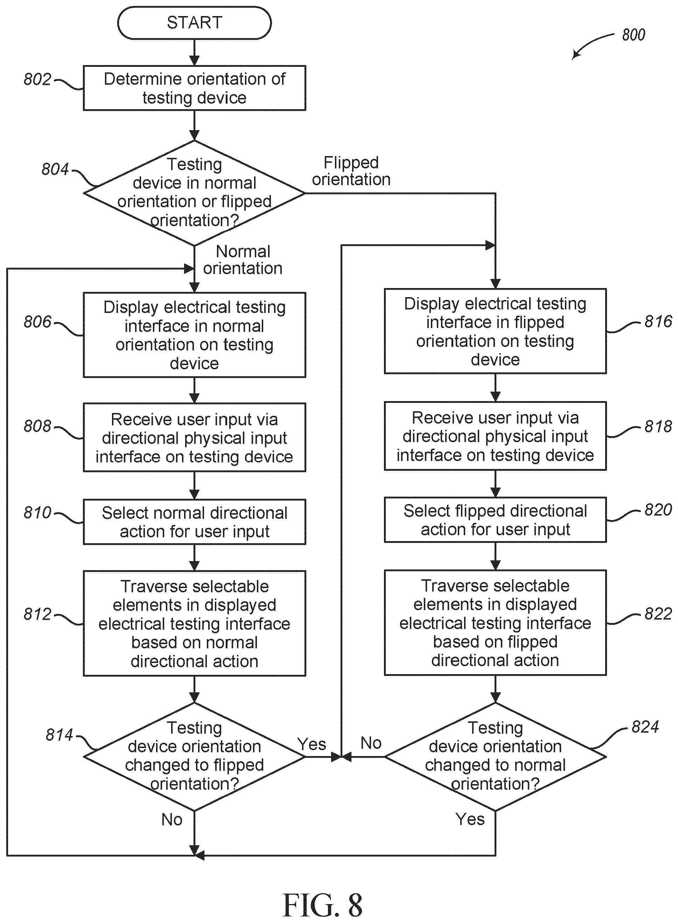

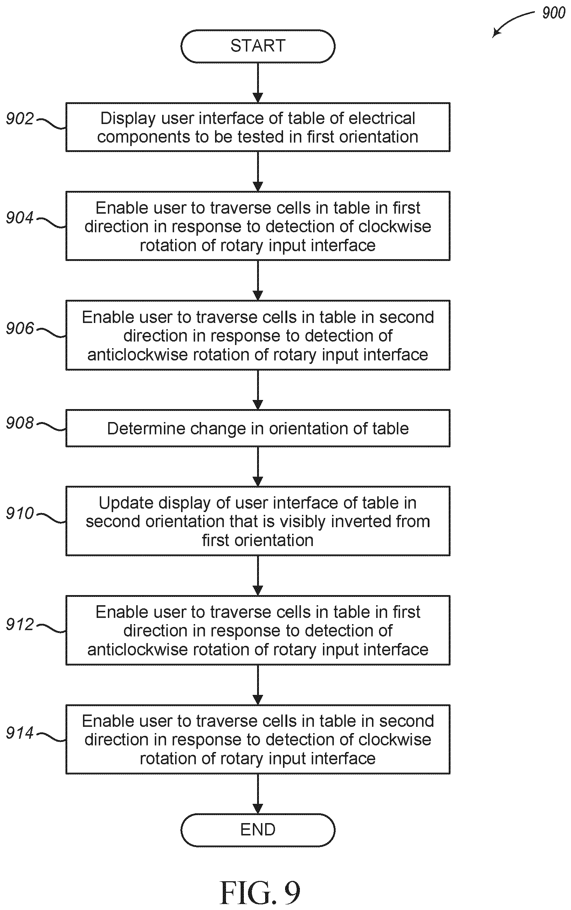

The operation of certain aspects will now be described with respect to Figures 8, 9, and 10A-10C. In at least one of various embodiments, processes 800 and 900 described in conjunction with Figures 8 and 9, respectively, may be implemented by or executed via circuitry or on one or more computing devices, such as electrical component testing device 102 in Figure 1 or electrical component testing device 202 in Figure 2.

Figure 8 illustrates a logical flow diagram showing one embodiment of a process 800 for determining an orientation of an electrical component testing device and flipping actions associated with its physical inputs in accordance with embodiments described herein.

Process 800 begins, after a start block, at block 802, where an orientation of the electrical component testing device is determined. The electrical component testing device may be positioned in a normal orientation or in a flipped orientation (also referred to as an inverted orientation). In general, the electrical component testing device is in the flipped orientation when it is rotated 180 degrees from the normal orientation, with the normal orientation being the standard positioning of the electrical component testing device during use. In some embodiments, the orientation is determined using an accelerometer or gyroscope. In other embodiments, a user may manually change a setting identifying whether the electrical component testing device is in a normal orientation or in a flipped orientation.

Process 800 proceeds, after block 802, to decision block 804, where a determination is made whether the electrical component testing device is in the normal orientation or in the flipped orientation. If the electrical component testing device is in the normal orientation, then process 800 flows to block 806. But if the electrical component testing device is in the flipped orientation, then process 800 flows to block 816.

At block 806, an electrical testing interface is displayed on the electrical component testing device in a normal orientation. In some embodiments, the electrical testing interface is a user interface of an electrical test application that is testing an electrical component, such as the electrical test application 520 shown in Figure 5B. In other embodiments, the electrical testing interface is a user interface of a table of electrical components to be tested, such as the table 512 shown in Figure 5B.

Process 800 proceeds, after block 806, to block 808, where user input is received via a directional physical input interface on the electrical component testing device. Examples of the directional physical input interface may include, but are not limited to, a rotary input interface, up/down (or vertical) buttons, left/right (or horizontal) buttons, up/down (or vertical) scroll wheel, left/right (or horizontal) scroll wheel, multi-directional touchpoint button, rotary encoder, rotary knobs, jog dial, jog wheel, shuttle dial, shuttle wheel, or other physical input interfaces that have a directional relationship to the orientation of the electrical component testing device.

Process 800 continues, after block 808, at block 810, where a normal directional action or behavior is selected for the user input. As one example, a right directional action may be selected in response to a clockwise rotational input to a rotary input interface. In another example, a left directional action may be selected in response to an anti-clockwise (or counter-clockwise) rotational input to a rotary input interface. As another example, an up directional action may be selected in response to a user pushing an up button. As yet another example, an up directional action may be selected in response to a user scrolling an up/down scroll wheel in an up direction. In yet another example, a right directional action may be selected in response to a user pushing a right button.

Process 800 proceeds, after block 810, to block 812, where one or more selectable elements in the electrical testing interface are traversed based on the normal directional action. In various embodiments, a selection icon may be moved in a direction of the normal directional action. Continuing the examples above, the selection icon may be moved right based on the right directional action selected in response to a clockwise rotational input to a rotary input interface. In another example, the selection icon may be moved left based on the left directional action selected in response to an anti-clockwise (or counter-clockwise) rotational input to a rotary input interface. As another example, the selection icon may be moved up based on the up directional action selected in response to a user pushing an up button. As yet another example, the selection icon may be moved up based on the up directional action selected in response to a user scrolling an up/down scroll wheel in an up direction. In yet another example, the selection icon may be moved right based on the right directional action may be selected in response to a user pushing a right button.

Process 800 continues, after block 812, at decision block 814, where a determination is made whether the orientation of the electrical component testing device has changed to the flipped orientation. Various embodiments of block 802 may be employed to determine the current orientation of the electrical component testing device, which may be compared to the previous orientation of the electrical component testing device to determine if the orientation has changed. If the orientation of the electrical component testing device has changed to the flipped orientation, process 800 flows to block 816; otherwise, process 800 loops to block 806 to continue operations of the electrical component testing device in the normal orientation.

If, at decision block 804 or at decision block 814, it is determined that the electrical component testing device is in the flipped orientation, process 800 flows to block 816.

At block 816, the electrical testing interface is displayed on the electrical component testing device in a flipped orientation. In the flipped orientation, the electrical testing interface is visually rotated 180 degrees from the normal orientation, or visually inverted from the normal orientation (such that a user can still read text on the electrical testing interface as if it is in normal orientation).

Process 800 proceeds, after block 816, to block 818, where user input is received via a directional physical input interface on the electrical component testing device. In various embodiments, block 818 may employ embodiments of block 808 to receive the user input via a directional physical input interface.

Process 800 continues, after block 818, at block 820, where a flipped directional action or behavior is selected for the user input. In some embodiments, the flipped direction action may also be referred to as an inverted or opposite action. As one example, a left directional action may be selected in response to a clockwise rotational input to a rotary input interface. In another example, a right directional action may be selected in response to an anti-clockwise (or counter-clockwise) rotational input to a rotary input interface. As another example, a down directional action may be selected in response to a user pushing an up button. As yet another example, a down directional action may be selected in response to a user scrolling an up/down scroll wheel in an up direction. In yet another example, a left directional action may be selected in response to a user pushing a right button.

Process 800 proceeds, after block 820, to block 822, where one or more selectable elements in the electrical testing interface are traversed based on the flipped directional action. In various embodiments, a selection icon may be moved in a direction of the normal directional action. In this way, the selectable elements are traversed (or the selection icon is moved) in a flipped, opposite, or inverted direction when the electrical component testing device is in the flipped orientation compared to their normal traversal when the electrical component testing device is in the normal orientation.

Continuing the examples above, the selection icon may be moved left based on the left directional action selected in response to a clockwise rotational input to a rotary input interface. In another example, the selection icon may be moved right based on the right directional action selected in response to an anti-clockwise (or counter-clockwise) rotational input to a rotary input interface. As another example, the selection icon may be moved down based on the down directional action selected in response to a user pushing an up button. As yet another example, the selection icon may be moved down based on the down directional action selected in response to a user scrolling an up/down scroll wheel in an up direction. In yet another example, the selection icon may be moved left based on the left directional action may be selected in response to a user pushing a right button.

Process 800 continues, after block 822, at decision block 824, where a determination is made whether the orientation of the electrical component testing device has changed to the normal orientation. Various embodiments of block 802 may be employed to determine the current orientation of the electrical component testing device, which may be compared to the previous orientation of the electrical component testing device to determine if the orientation has changed. If the orientation of the electrical component testing device has changed to the normal orientation, process 800 flows to block 806; otherwise, process 800 loops to block 816 to continue operations of the electrical component testing device in the flipped orientation.

Figure 9 illustrates a logical flow diagram showing one embodiment of a process 900 for determining a change in the orientation of an electrical component testing device and enabling a user to traverse cells in a table based on the changed orientation of the electrical component testing device in accordance with embodiments described herein.

Process 900 begins, after a start block, at block 902, where a user interface of a table of electrical components to be tested is displayed in a first orientation on an electrical component testing device. The user interface may be similar to table 512 shown in Figure 5A. In at least one embodiment, the first orientation may be considered the normal orientation of the electrical component testing device, similar to what is described in conjunction with Figure 8.

Process 900 proceeds, after block 902, to block 904, where the user of the electrical component testing device is enabled to traverse cells in the table in a first direction in response to detection of a clockwise rotation of a rotary input interface. For example, the user may be enabled to traverse cells from left to right on a single row by manipulating the rotary input interface in a clockwise rotation.

Process 900 continues, after block 904, at block 906, where the user of the electrical component testing device is enabled to traverse cells in the table in a second direction in response to detection of an anti-clockwise (or counter-clockwise) rotation of the rotary input interface, where the second direction is in an opposite direction from the first direction. For example, the user may be enabled to traverse cells from right to left on a single row by manipulating the rotary input interface in an anti-clockwise rotation.

Process 900 proceeds, after block 906, to block 908, where the orientation of the table is changed from the first orientation (e.g., normal orientation) to a second orientation (e.g., a flipped orientation). In various embodiments, the orientation of the table is changed in response to a change in the orientation of the electrical component testing device. In various embodiments, a user may rotate the electrical component testing device from a normal orientation to a flipped orientation. In other embodiments, the user may manually change a setting indicating that the electrical component testing device has changed from a normal orientation to a flipped orientation.

Process 900 continues, after block 908, at block 910, where the display of the user interface of a table of electrical components to be tested is updated to be in a second orientation (e.g., flipped orientation) on the electrical component testing device. The second orientation is visibly inverted from the first orientation.

Process 900 proceeds, after block 910, to block 912, where the user of the electrical component testing device is enabled to traverse cells in the table in the first direction in response to detection of an anti-clockwise (or counter-clockwise) rotation of the rotary input interface. For example, the user may be enabled to traverse cells from left to right on a single row by manipulating the rotary input interface in an anti-clockwise (or counter-clockwise) rotation.

Process 900 continues, after block 904, at block 906, where the user of the electrical component testing device is enabled to traverse cells in the table in the second direction in response to detection of a clockwise rotation of the rotary input interface. For example, the user may be enabled to traverse cells from right to left on a single row by manipulating the rotary input interface in a clockwise rotation.

After block 914, process 900 terminates or otherwise returns to a calling process to perform other actions. In some embodiments, process 900 may loop to block 902 if the orientation of the electrical component testing device to put into the first orientation.

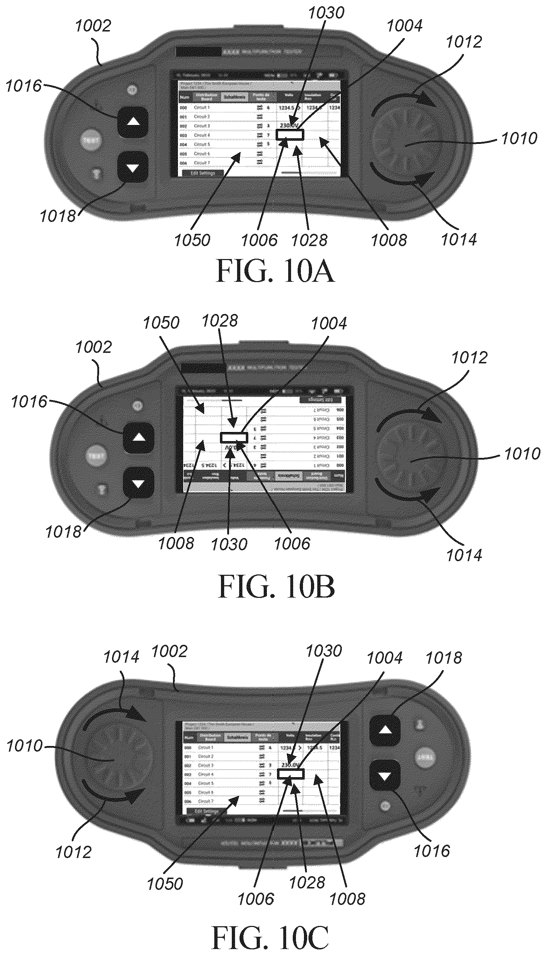

Figures 10A-10C illustrate an example embodiment of changing an orientation of an electrical component testing device 1002 in accordance with embodiments described herein.

Figure 10A shows the electrical component testing device 1002 in a normal orientation (or first orientation). The electrical component testing device 1002 is displaying a table 1050 similar to what is shown in Figure 5A. The electrical component testing device 1002 includes a rotary input interface 1010, an up button 1016, and a down button 1018.

In the normal orientation, the user rotates the rotary input interface 1010 in a clockwise direction 1012 to move selection icon 1004 from cell 1006 to cell 1008 within the table 1050. The user can move the selection icon 1004 from cell 1006 to cell 1030 in response to pushing up button 1016, and the user can move the selection icon 1004 from cell 1006 to cell 1028 in response to pushing down button 1018.

If the user puts the electrical component testing device 1002 into a flipped orientation, then the electrical component testing device 1002 displays the table 1050 in a flipped orientation, which is shown in Figure 10B. In the flipped orientation, the user rotates the rotary input interface 1010 in an anti-clockwise direction 1014 to move selection icon 1004 from cell 1006 to cell 1008 within the table 1050. The user can move the selection icon 1004 from cell 1006 to cell 1030 in response to pushing down button 1018, and the user can move the selection icon 1004 from cell 1006 to cell 1028 in response to pushing up button 1018.

In Figure 10C, the orientation of table 1050 and the functioning of the rotary input interface 1010, the up button 1016, and the down button 1018 are the same as shown in Figure 10B, but with the electrical component testing device 1002 being visibly shown in the flipped orientation so that the user can read the table as they normally would.

The following are exemplary implementations and features described herein.

A method may be summarized as comprising: displaying a user interface showing a table of electrical components to be tested; receiving, via the user interface, a user input activating a target cell associated with an electrical component in the table; identifying an electrical test application based on the target cell; executing the electrical test application on a testing device to test the electrical component; and receiving, from the electrical test application, a result of testing the electrical component.

The method may optionally include: populating the target cell in the table with the result; and updating the user interface showing the table of electrical components with the result populated in the target cell.

The method may optionally include: displaying the user interface showing the table of electrical components on the testing device.

The method may optionally include: displaying the user interface showing the table of electrical components on a user computing device that is separate from the testing device that is executing the electrical test application.

The method may optionally include: transmitting a command from a user computing device to the testing device instructing the testing device to execute the electrical test application on the testing device.

The method may optionally include: in response to receiving the result of testing the electrical component: identifying a second electrical test application based on the target cell being associated with a sequence of a plurality of tests; executing the second electrical test application to test the electrical component; receiving, from the second electrical test application, a second result of testing the electrical component; and populating a second target cell associated with the electrical component in the table with the second result.

The method may optionally include: in response to receiving the result of testing the electrical component: determining a second target cell in the table; and updating the user interface to identify the second target cell.

The method may optionally include: receiving, via the user interface, a second user input activating a second target cell associated with the electrical component in the table; identifying a second electrical test application based on the second target cell, wherein the second electrical test application is different from the electrical test application; executing the second electrical test application on the testing device to test the electrical component; receiving, from the second electrical test application, a second result of testing the electrical component; populating the second target cell in the table with the second result; and updating the user interface showing the table of electrical components with the second result populated in the second target cell.

The method may optionally include: identifying a row of the target cell in the table; determining the electrical component associated with the row; identifying a column of the target cell in the table; determining an electrical test associated with the column; and selecting the electrical test application based on the electrical component and the electrical test.

The method may optionally include: determining an orientation of the testing device; in response to determining that the orientation of the testing device is in a normal orientation: displaying an electrical testing interface for the electrical test application in the normal orientation on the testing device; receiving a second user input via a directional physical input interface on the testing device; selecting a normal directional action based on the second user input; and traversing selectable elements in the electrical testing interface based on the normal directional action; and in response to determining that the orientation of the testing device is in a flipped orientation: displaying an electrical testing interface for the electrical test application in the flipped orientation on the testing device, wherein the flipped orientation is visually inverted on the testing device from the normal orientation; receiving a third user input via the directional physical input interface on the testing device; selecting a flipped directional action based on the third user input; and traversing the selectable elements in the electrical testing interface based on the flipped directional action.

The method may optionally include: determining an orientation of the testing device; in response to determining that the orientation of the testing device is in a normal orientation: displaying the user interface showing the table of electrical components to be tested in the normal orientation on the testing device; receiving a first directional user input via a directional physical input interface on the testing device; selecting a normal directional action based on the first directional user input; and traversing cells in the table based on the normal directional action; and in response to determining that the orientation of the testing device is in a flipped orientation: displaying the user interface showing the table of electrical components to be tested in the flipped orientation on the testing device, wherein the flipped orientation is visually inverted on the testing device from the normal orientation; receiving a second directional user input via the directional physical input interface on the testing device; selecting a flipped directional action based on the second directional user input; and traversing the cells in the table based on the flipped directional action.

A testing device may be summarized as comprising: at least one socket input configured to electrically couple the testing device to at least one electrical component; a display device configured to display a user interface showing a table of electrical components to be tested; a memory configured to store computer instructions; and a processor system configured to execute the computer instructions to: display, via the display device, the user interface showing the table of electrical components to be tested; receive, via the user interface, a user input activating a target cell associated with an electrical component in the table; identify an electrical test application based on the target cell; execute the electrical test application on a testing device to test the electrical component; and receive, via the electrical test application, a result of testing the electrical component.

The testing device may optionally: in response to receiving the result of testing the electrical component: identify a second electrical test application in response to the target cell being associated with a sequence of a plurality of tests; execute the second electrical test application to test the electrical component; receive, from the second electrical test application, a second result of testing the electrical component; and populate a second target cell associated with the electrical component in the table with the second result.

The testing device may optionally: receive, via the user interface, a second user input activating a second target cell associated with a second electrical component in the table, wherein the selected electrical component is separate from the electrical component; identify a second electrical test application based on the second target cell; execute the second electrical test application on the testing device to test the second electrical component; receive, from the second electrical test application, a second result of testing the second electrical component; populate the second target cell in the table with the second result; and update the user interface showing the table of electrical components with the second result populated in the second target cell.

The testing device may optionally include: a directional physical input interface configured to receive directional user input; and may optionally: in response to determining that an orientation of the testing device is in a normal orientation: display the user interface showing the table of electrical components to be tested in the normal orientation on the testing device; receive a first directional user input via the directional physical input interface; select a normal directional action based on the first directional user input; and traverse cells in the table shown in the user interface based on the normal directional action; and in response to determining that the orientation of the testing device is in a flipped orientation: display the user interface showing the table of electrical components to be tested in the flipped orientation on the testing device, wherein the flipped orientation is visually inverted on the testing device from the normal orientation; receive a second directional user input via the directional physical input interface; select a flipped directional action based on the second directional user input; and traverse the cells in the table shown in the user interface based on the flipped directional action.

The testing device may optionally include: a directional physical input interface configured to receive directional user input; and may optionally: determine an orientation of the testing device; in response to determining that the orientation of the testing device is in a normal orientation: display a second user interface of the electrical test application in the normal orientation on the testing device; receive a first directional user input via the directional physical input interface; and traverse selectable elements in the second user interface based on a normal directional action associated with the first directional user input; and in response to determining that the orientation of the testing device is in a flipped orientation: display the second user interface of the electrical test application in the flipped orientation on the testing device, wherein the flipped orientation is visually inverted on the testing device from the normal orientation; receive a second directional user input via the directional physical input interface; and traverse the selectable elements in the second user interface based on a flipped directional action associated with the second directional user input.

A system may be summarized as comprising: a user computing device and an electrical component testing device. The user computing device may be summarized as comprising: a first display device configured to display a user interface showing a table of electrical components to be tested; a first memory configured to store first computer instructions; and a first processor system configured to execute the first computer instructions to: display, via the first display device, the user interface showing the table of electrical components to be tested; receive, via the user interface, a user input activating a target cell associated with an electrical component in the table; identify an electrical test application based on the target cell; and receive a result of testing the electrical component. The electrical component testing device may be summarized as comprising: a second memory configured to store second computer instructions; and a second processor system configured to execute the second computer instructions to: receive, from the user computing device, a message identifying the electrical test application; in response to receiving the message, automatically execute the electrical test application to test the electrical component; receive, via the electrical test application, the result of testing the electrical component; and provide the result of testing the electrical component to the user computing device.

The user computing device of the system may optionally: in response to receiving the result of testing the electrical component: identify a second electrical test application based on the target cell being associated with a sequence of a plurality of tests; provide a second message to the electrical component testing device to automatically execute the second electrical test application to test the electrical component; receive, from the electrical component testing device, a second result of testing the electrical component; and automatically populate a second target cell associated with the electrical component in the table with the second result.

The electrical computing testing device of the system may optionally: receive a second message from the user computing device identifying a second electrical test application; in response to receiving the second message, automatically execute the second electrical test application to test the electrical component; receive, via the second electrical test application, a second result of testing the electrical component; and provide the second result of testing the electrical component to the user computing device to be automatically populated into a second target cell of the table.

The electrical computing testing device of the system may optionally: determine an orientation of the electrical component testing device; in response to determining that the orientation of the testing device is in a normal orientation: display a second user interface associated with the electrical test application in the normal orientation on the testing device; receive a first directional user input via a directional physical input interface; select a normal directional action based on the first directional user input; and traverse selectable elements in the second user interface based on the normal directional action; and in response to determining that the orientation of the electrical component testing device is in a flipped orientation: display the second user interface associated with the electrical test application in the flipped orientation on the testing device, wherein the flipped orientation is visually inverted on the electrical component testing device from the normal orientation; receive a second directional user input via the directional physical input interface; select a flipped directional action based on the second directional user input; and traverse the selectable elements in the second user interface based on the flipped directional action.

The various features described above can be combined to provide further features and embodiments. These and other changes can be made in light of the above-detailed description. In general, in the following claims, the terms used should not be construed to limit the claims to the specific features and embodiments disclosed in the specification and the claims, but should be construed to include all possible features along with the full scope of equivalents to which such claims are entitled. Accordingly, the claims are not limited by the disclosure.

## Claims

1. A method, comprising:
displaying a user interface showing a table of electrical components to be tested;
receiving, via the user interface, a user input activating a target cell associated with an electrical component in the table;
identifying an electrical test application based on the target cell;
executing the electrical test application on a testing device to test the electrical component; and
receiving, from the electrical test application, a result of testing the electrical component.

2. The method of claim 1, further comprising:
populating the target cell in the table with the result; and
updating the user interface showing the table of electrical components with the result populated in the target cell.

3. The method of claim 1 or 2, wherein displaying the user interface showing the table of electrical components to be tested comprises:
displaying the user interface showing the table of electrical components on the testing device.

4. The method of any of claims 1 to 3, wherein displaying the user interface showing the table of electrical components to be tested comprises:
displaying the user interface showing the table of electrical components on a user computing device that is separate from the testing device that is executing the electrical test application.

5. The method of any of claims 1 to 4, wherein executing the electrical test application to test the electrical component comprises:
transmitting a command from a user computing device to the testing device instructing the testing device to execute the electrical test application on the testing device.

6. The method of any of claims 1 to 5, further comprising:
in response to receiving the result of testing the electrical component:
identifying a second electrical test application based on the target cell being associated with a sequence of a plurality of tests;
executing the second electrical test application to test the electrical component;
receiving, from the second electrical test application, a second result of testing the electrical component; and
populating a second target cell associated with the electrical component in the table with the second result.

7. The method of any of claims 1 to 6, further comprising:
in response to receiving the result of testing the electrical component:
determining a second target cell in the table; and
updating the user interface to identify the second target cell.

8. The method of any of claims 1 to 7, further comprising:
receiving, via the user interface, a second user input activating a second target cell associated with the electrical component in the table;
identifying a second electrical test application based on the second target cell, wherein the second electrical test application is different from the electrical test application;
executing the second electrical test application on the testing device to test the electrical component;
receiving, from the second electrical test application, a second result of testing the electrical component;
populating the second target cell in the table with the second result; and
updating the user interface showing the table of electrical components with the second result populated in the second target cell.

9. The method of any of claims 1 to 8, wherein identifying the electrical test application based on the target cell comprises:
identifying a row of the target cell in the table;
determining the electrical component associated with the row;
identifying a column of the target cell in the table;
determining an electrical test associated with the column; and
selecting the electrical test application based on the electrical component and the electrical test.

10. The method of any of claims 1 to 9, further comprising:
determining an orientation of the testing device;
in response to determining that the orientation of the testing device is in a normal orientation:
displaying an electrical testing interface for the electrical test application in the normal orientation on the testing device;
receiving a second user input via a directional physical input interface on the testing device;
selecting a normal directional action based on the second user input; and
traversing selectable elements in the electrical testing interface based on the normal directional action; and
in response to determining that the orientation of the testing device is in a flipped orientation:
displaying an electrical testing interface for the electrical test application in the flipped orientation on the testing device, wherein the flipped orientation is visually inverted on the testing device from the normal orientation;
receiving a third user input via the directional physical input interface on the testing device;
selecting a flipped directional action based on the third user input; and
traversing the selectable elements in the electrical testing interface based on the flipped directional action.

11. The method of any of claims 1 to 10, further comprising:
determining an orientation of the testing device;
in response to determining that the orientation of the testing device is in a normal orientation:
displaying the user interface showing the table of electrical components to be tested in the normal orientation on the testing device;
receiving a first directional user input via a directional physical input interface on the testing device;
selecting a normal directional action based on the first directional user input; and
traversing cells in the table based on the normal directional action; and
in response to determining that the orientation of the testing device is in a flipped orientation:
displaying the user interface showing the table of electrical components to be tested in the flipped orientation on the testing device, wherein the flipped orientation is visually inverted on the testing device from the normal orientation;
receiving a second directional user input via the directional physical input interface on the testing device;
selecting a flipped directional action based on the second directional user input; and
traversing the cells in the table based on the flipped directional action.

12. A testing device, comprising:
at least one socket input configured to electrically couple the testing device to at least one electrical component;
a display device configured to display a user interface showing a table of electrical components to be tested;
a memory configured to store computer instructions; and
a processor system configured to execute the computer instructions to carry out the method of any of claims 1 to 11.

13. A system, comprising:
a user computing device, comprising:
a first display device configured to display a user interface showing a table of electrical components to be tested;
a first memory configured to store first computer instructions; and
a first processor system configured to execute the first computer instructions to:
display, via the first display device, the user interface showing the table of electrical components to be tested;
receive, via the user interface, a user input activating a target cell associated with an electrical component in the table;
identify an electrical test application based on the target cell; and
receive a result of testing the electrical component; and
an electrical component testing device, comprising:
a second memory configured to store second computer instructions; and
a second processor system configured to execute the second computer instructions to:
receive, from the user computing device, a message identifying the electrical test application;
in response to receiving the message, automatically execute the electrical test application to test the electrical component;
receive, via the electrical test application, the result of testing the electrical component; and
provide the result of testing the electrical component to the user computing device.

14. The system of claim 13, wherein the first processor system is configured to further execute the first computer instructions to:
in response to receiving the result of testing the electrical component:
identify a second electrical test application based on the target cell being associated with a sequence of a plurality of tests;
provide a second message to the electrical component testing device to automatically execute the second electrical test application to test the electrical component;
receive, from the electrical component testing device, a second result of testing the electrical component; and
automatically populate a second target cell associated with the electrical component in the table with the second result.

15. The system of claim 13 or 14, wherein the second processor system is configured to further execute the second computer instructions to:
receive a second message from the user computing device identifying a second electrical test application;
in response to receiving the second message, automatically execute the second electrical test application to test the electrical component;
receive, via the second electrical test application, a second result of testing the electrical component; and
provide the second result of testing the electrical component to the user computing device to be automatically populated into a second target cell of the table.
